# EUROPÄISCHE PATENTSCHRIFT

(11) **EP 2 308 274 B1**
(45) Veröffentlichungstag und Bekanntmachung des Hinweises auf die Patenterteilung: **09.05.2012**
(21) Anmeldenummer: 09780632.7
(22) Anmeldetag: 15.07.2009
(51) Int. Cl.: H05K 1/18, H05K 1/02, H05K 1/03

(54) **LEITERPLATINE MIT ELEKTRONISCHEM BAUELEMENT**
PRINTED CIRCUIT BOARD WITH ELECTRONIC COMPONENT
CIRCUIT IMPRIMÉ AVEC COMPOSANT ÉLECTRONIQUE

(30) Priorität: 31.07.2008 DE 102008040906
(43) Veröffentlichungstag der Anmeldung: 13.04.2011
(73) Patentinhaber: Robert Bosch GmbH, 70442 Stuttgart (DE)
(72) Erfinder: KUGLER, Andreas, 73553 Alfdorf (DE); VOIGTLAENDER, Klaus, 73117 Wangen (DE); KIMMICH, Peter, 71101 Schoenaich (DE)
(86) Internationale Anmeldenummer: PCT/EP2009/059062
(87) Internationale Veröffentlichungsnummer: WO 2010/012594

(56) Entgegenhaltungen:
- EP-A1- 1 478 023
- WO-A1-2005/104635
- US-A- 5 111 278
- US-A- 5 268 812
- US-A1- 2006 011 383
- US-A1- 2006 033 199
- US-A1- 2006 273 814
- US-A1- 2007 176 613
- US-B1- 6 400 573
- US-B1- 6 490 159

## Beschreibung

Die Erfindung betrifft eine Leiterplatine mit einem flächigen Platinensubstrat und mit mindestens einem elektronischen Bauelement.

### Stand der Technik

Steuergeräte für eine elektronische Ansteuerung von Leistungsverbrauchern werden üblicherweise mit diskreten oder integrierten Bauteilen, die auf Platinensubstraten angeordnet sind, aufgebaut. Als Leistungsverbraucher kommen Elektromotoren, Magnetventile, Piezoaktuatoren, Hydraulikanordnungen, Heizelemente, Peltierelemente, DC-DC-Wandler, AC-DC-Wandler, DC-AC-Wandler und AC-AC-Wandler in Frage. Insbesondere ist es bekannt, für die Ansteuerung von elektrischen Maschinen Schaltungen in Form von H-Brücken oder B6-Brücken zu verwenden.

In den Steuergeräten, insbesondere für Leistungsverbraucher höherer Leistungsklassen, treten häufig erhebliche Leitungslängen zwischen einzelnen Bauelementen auf. Diese Leitungslängen führen bei einem höherfrequenten Betrieb der Steuergeräte zu Erwärmungen durch Blindwiderstand, zu Übersprechem und zu Emissionen durch elektromagnetische Abstrahlung und Reflektion. Die im Stand der Technik verwendeten Aufbauten und Verbindungsarten lassen keine niederinduktiven Verbindungen zu, welche sich vorteilhaft auswirken könnten. Insbesondere beim Einsatz von Bauelementen wie sogenannten High- und Low-Side-Schaltern, die elektrische Anschlussflächen sowohl auf einer Oberseite als auch auf einer Unterseite aufweisen, müssen zusätzliche Gehäusekonstruktionen erzeugt werden, die zu langen elektrischen Verbindungen führen.

Aus der US 5,111,278 A ist eine Leiterplatine bekannt, die aus mehreren Substratschichten und darauf beziehungsweise dazwischen angeordneten Bauelementen besteht. Zum Abführen der Wärme aus den Substratschichten sind thermisch leitfähige Schichten beziehungsweise Durchkontaktierungen vorgesehen. Eine der Leiterplatine zugeordnete Wärmesenke weist mehrere Kühlmittelkanäle auf und kann in die Leiterplatine integriert werden.

Die US 5,268,812 A offenbart eine Platine mit integrierten Kühlmittelkanälen. Die Kühlmittelkanäle sind mit einer Flüssigkeit gefüllt, die entsprechend vaporisiert und kondensiert, um Hitze von Bauteilen in der Platine abzuführen. Die US 6,490,159 B1 offenbart eine mehrlagige Leiterplatine, die Kanäle aufweist, in denen mittels einer Wärmepumpe ein kühlendes Medium geführt wird, um Wärme von der Leiterplatine abzuführen. Die US 2006/0273814 A1 offenbart eine als flexible Leiterplatte ausgebildete Leiterplatine, die in einem Gehäuse angeordnet ist, das als Wärmeleitrohr wirkt und insofern dem Abführen von Wärme von der Leiterplatine dient.

Aufgabe der Erfindung ist es, eine Leiterplatine bereitzustellen, bei der Mängel wie Erwärmung, Übersprecher und elektromagnetische Belastung reduziert oder beseitigt sind.

### Offenbarung der Erfindung

Diese Aufgabe wird durch eine Leiterplatine mit den Merkmalen des Anspruchs 1 gelöst. Es ist vorgesehen, dass das Bauelement innerhalb des Platinensubstrats angeordnet ist. Aufgrund der Anordnung ist es möglich, dass das Bauelement ohne aufwändige Gehäusekonstruktion auskommt und gegenüber möglichen auf der Leiterplatine angeordneten Bauelementen mit geringem Abstand angeordnet ist. Daraus ergibt sich, dass Verbindungen von dem Bauelement zu anderen Bauelementen in ihrer Länge minimiert werden können. Die Minimierung der Länge führt wiederum zu induktionsoptimierten Verbindungen. Diese integrierte Lösung zeichnet sich weiter durch eine geringe Temperaturbelastung und eine sehr große Temperaturwechselfestigkeit aus, da das Bauelement im Platinensubstrat gegenüber einer Außentemperatur sowie anderen Bauelementen thermisch isoliert ist. Zudem verkleinert sich bei der erfindungsgemäßen Vorrichtung der Bauraum gegenüber dem Stand der Technik, da das Bauelement innerhalb der Leiterplatine integriert ist. Somit ergeben sich auch Gewichtsvorteile sowie Kostenvorteile, da Material am Platinensubstrat sowie an den Verbindungen eingespart wird. Als elektronisches Bauelement innerhalb der Platine eignen sich insbesondere Halbleiterelemente wie Transistoren, insbesondere Leistungstransistoren. Das Einsparen der Gehäuse führt zu weiteren Material-, Gewichts- und Kostenvorteilen bei einer Herstellung. Ferner kann es vorgesehen sein, weitere für eine elektrische Schaltung notwendige Bauelemente wie Kondensatoren, Widerstände, Spulen, Dioden, ASICs, ICs, Mikrocontroller und Shunts gemeinsam mit der Leiterplatine zu verwenden. Diese können entweder in herkömmlicher Art wie durch Löten und/oder durch Kleben mit dem Platinensubstrat verbunden werden. Ferner ist es denkbar, auch diese elektrischen Bauelemente innerhalb des Platinensubstrats anzuordnen.

Nach einer Weiterbildung der Erfindung ist vorgesehen, dass die Leiterplatine als Leiterplatte ausgebildet ist. Die Leiterplatte stellt ein flächenförmiges, vorzugsweise tafelförmiges, Gebilde dar.

Erfindungsgemäß ist vorgesehen, dass das Platinensubstrat mehrere, übereinander liegende, elektrisch isolierende Platinenschichten aufweist. Der Aufbau des Platinensubstrats durch mehrere Platinenschichten ermöglicht es, innerhalb der Leiterplatine angeordnete Bauelemente sehr gut thermisch sowie elektrotechnisch zu isolieren. Ferner kann eine Dicke der Leiterplatine weitgehend frei gewählt werden, da der Aufbau der Leiterplatine in beliebiger Lagenzahl erfolgen kann.

Erfindungsgemäß ist vorgesehen, dass das Bauelement innerhalb einer der Platinenschichten angeordnet ist. Auf diese Weise ist es möglich, zunächst eine Platinenschicht zu erzeugen, in welcher das Bauelement angeordnet wird. Durch die Verwendung mehrerer Platinenschichten wird diese erste Platinenschicht durch weitere Platinenschichten überdeckt. Das Überdecken führt zu der guten thermischen und elektrischen Isolation sowie Abschirmung des Bauelements.

Erfindungsgemäß ist vorgesehen, dass die Leiterplatine mindestens bereichsweise mindestens eine elektrisch leitende und/oder wärmeleitende Leiterschicht aufweist. Diese Leiterschicht wird verwendet, um Bauelemente elektrisch und/oder thermisch miteinander zu verbinden. Um dies gezielt durchführen zu können, ist die Leiterplatine vorzugsweise nur bereichsweise mit der Leiterschicht versehen, sodass sich einzelne Verbindungspfade in Form von Leiterschichtbereichen ausbilden, die beispielsweise zwei Bauelemente miteinander verbinden. Ferner können großflächige Potentialflächen durch die Leiterschicht, insbesondere durch mehrere Leiterschichten, vorgesehen sein, welche zu einer guten Abschirmung elektromagnetischer Emissionen führen.

In einer nicht erfindungsgemäßen Ausführungsform kann vorgesehen sein, dass die Leiterschicht als Außenleiterschicht ausgebildet ist, die auf einer Oberfläche des Platinensubstrats angeordnet ist. Die Außenleiterschicht dient insbesondere dem Aufbau von Verbindungen zwischen Bauelementen, die an der Oberfläche des Platinensubstrats angeordnet sind sowie der Wärmeabfuhr nach außen.

Erfindungsgemäß ist jedoch vorgesehen, dass die Leiterschicht als Innenleiterschicht ausgebildet ist, die zwischen zwei benachbarten Platinenschichten angeordnet ist. Die Innenleiterschicht dient insbesondere zum Aufbau von Verbindungen zwischen Bauelementen, die innerhalb des Platinensubstrats angeordnet sind sowie der Wärmeabfuhr von Wärme des Bauelements, das innerhalb des Platinensubstrats angeordnet ist.

Nach einer besonders vorteilhaften Weiterentwicklung der Erfindung ist mindestens eine Durchkontaktierung vorgesehen, die die Leiterschicht und/oder das Bauelement mit mindestens einer weiteren Leiterschicht und/oder mit mindestens einem weiteren Bauelement elektrisch und/oder wärmeleittechnisch miteinander verbindet. Die Verwendung der Durchkontaktierung ermöglicht es insbesondere, die Außenleiterschicht mit der Innenleiterschicht und/oder dem Bauelement zu verbinden, das innerhalb des Platinensubstrats liegt, wodurch das Bauelement eine Verbindung zur Außenleiterschicht und somit beispielsweise zu möglichen Bauelementen an der Oberfläche des Platinensubstrats erhält. Dabei ist es denkbar, dass die Durchkontaktierung zu der einen Oberfläche und der damit verbundenen Außenleiterschicht führen und eine andere Durchkontaktierung zu einer weiteren Oberfläche mit einer weiteren Außenleiterschicht führt. Die Durchkontaktierung wird vorzugsweise mittels einer Bohrung, wie zum Beispiel einer Laserbohrung, in das Platinensubstrat eingebracht. Dabei verläuft die Bohrung bis zu der Innenleiterschicht oder zu dem Bauelement. Abschließend wird zur Herstellung der Durchkontaktierung eine Metallisierung der Bohrung vorgenommen. Durchkontaktierungen zum Weiterleiten oder Ableiten von Wärme sind bevorzugt vollständig metallisch ausgefüllt. Die durch Durchkontaktierungen und den Leiterschichten hergestellten Verbindungen zu dem Bauelement innerhalb des Leitersubstrats führen zu einer Verkürzung der Verbindungen gegenüber dem Stand der Technik, was zu einer Verkleinerung der Induktivität der Verbindungen führt. Damit verbunden ist die Verringerung der elektromagnetischen Emissionen durch Abstrahlung und Reflektionen.

Erfindungsgemäß ist eine Kühlvorrichtung vorgesehen zur Kühlung von mindestens einer der Platinenschichten und/oder der Leiterschicht.
Aufgrund der Isolation innerhalb der Leiterplatine ist es sehr vorteilhaft, wenn das Bauelement gekühlt wird. Dies kann innerhalb der Leiterplatine von mehreren Seiten, insbesondere von zwei Seiten, des Bauelements erfolgen. Um eine besonders effektive Kühlung herbeizuführen, können mehrere Durchkontaktierungen von einer Innenleiterschicht und/oder Außenleiterschicht zu einem Bauelement vorgesehen sein. Ferner sind eine Mehrzahl von Durchkontaktierungen zwischen verschiedenen Leiterschichten denkbar.

In einer nicht erfindungsgemäßen Ausführungsform kann vorgesehen sein, dass die Kühlvorrichtung eine Kühlrippenanordnung ist, mit der die Außenleiterschicht wärmeleittechnisch wirkverbunden ist. Dabei ist es insbesondere vorgesehen, dass eine Mehrzahl von Kühlrippenanordnungen einseitig oder zweiseitig auf der Leiterplatine angeordnet sind. Die zweiseitige Anordnung führt zu einer zusätzlichen Verkürzung der Längen der Verbindungen zwischen dem Bauelement und einer der Außenleiterschichten.

Weiterhin ist vorgesehen, dass die Kühlvorrichtung zwischen zwei Platinenschichten mindestens einen Kühlmittelkanal aufweist. Die Verwendung eines Kühlmittelkanals ermöglicht, ein Kühlmittel durch das Platinensubstrat hindurchströmen zu lassen, was zu einer besonders effektiven Kühlung des Platinensubstrats sowie des innerhalb des Platinensubstrats angeordneten Bauelements führt. Die Anordnung des Kühlmittelkanals zwischen zwei Platinenschichten ermöglicht ein einfaches Einbringen des Kühlmittelkanals bei der Herstellung der Leiterplatine.

Erfindungsgemäß ist vorgesehen, dass der Kühlmittelkanal in der Innenleiterschicht angeordnet ist. Dies ist insbesondere dann vorteilhaft, wenn die Leiterschicht nur bereichsweise zwischen den Platinenschichten vorliegt. Somit ist es möglich, die bereits vorhandene Leiterschicht für den Kühlmittelkanal zu nutzen oder Bereiche zwischen den Platinenschichten, die nicht mit einer Leiterschicht versehen sind, als Kühlmittelkanal zu verwenden.

Erfindungsgemäß ist vorgesehen, dass der Kühlmittelkanal als randoffene Nut ausgebildet ist. Dies ermöglicht eine besonders einfache Herstellung des Kühlmittelkanals, in dem in die Leiterschicht eine Nut eingebracht wird, was beispielsweise durch ein spanendes Bearbeiten oder Ätzen geschehen kann. Dieser Vorgang kann bereits bei der Herstellung der Leiterschicht berücksichtigt werden, ohne dass ein zusätzlicher Produktionsschritt notwendig ist.

Erfindungsgemäß ist vorgesehen, dass die randoffene Nut von einer Abdeckung abgedeckt ist. Durch das Abdecken der randoffenen Nut entsteht ein geschlossener Kühlmittelkanal. Dabei ist zu beachten, dass die Abdeckung die randoffene Nut kühlmitteldicht abdeckt.

Erfindungsgemäß ist vorgesehen, dass die Abdeckung eine weitere Innenleiterschicht und/oder eine Platinenschicht und/oder eine weitere randoffene Nut eines weiteren Kühlmittelkanals ist. Beim Abdecken der randoffenen Nut durch eine weitere randoffene Nut ist vorgesehen, dass beide Nuten mit ihren Öffnungen einander zugewandt liegen (face to face), wodurch ein gemeinsamer, geschlossener Kühlmittelkanal entsteht.

Erfindungsgemäß ist vorgesehen, dass der Kühlmittelkanal als Wärmeleitrohr (heat pipe) ausgebildet ist. Dies führt zu einer besonders effektiven Kühlung. Dabei kann es vorgesehen sein, dass der Kühlmittelkanal mit einem Raum verbunden ist, der sich in oder durch mindestens eine der Platinenschichten erstreckt. Da innerhalb eines Wärmeleitrohrs sowohl eine Gasphase als auch eine Flüssigphase für einen Wärmetransport verwendet wird, muss der Kühlmittelkanal und der Raum abgeschlossen und gasdicht ausgeführt sein.

Nach einer Weiterbildung der Erfindung ist vorgesehen, dass die Leiterplatine als flexible Leiterplatine ausgebildet ist. Die Ausbildung als flexible Leiterplatine ermöglicht, die Leiterplatine sowohl in schwer zugänglichen Orten als auch in kleinen Bauräumen unterzubringen. Hierbei ist es besonders vorteilhaft, wenn innerhalb der Leiterplatine ausreichend dünne Bauelemente angeordnet sind, sodass auch diese als flexibel betrachtet und verwendet werden können. Beispielsweise kann vorgesehen sein, die Leiterplatine innerhalb eines Zylinderraums gerollt anzuordnen.

Die Erfindung betrifft ferner ein Verfahren mit den Merkmalen des Anspruchs 5 zur Herstellung einer Leiterplatine, insbesondere in der vorangegangen beschriebenen Form, mit einem flächigen Platinensubstrat, dem mindestens ein elektronisches Bauelement zugeordnet wird, wobei vorgesehen ist, dass das Bauelement innerhalb des Platinensubstrats angeordnet wird.

Bei dem erfindungsgemäßen Verfahren ist vorgesehen, dass das Platinensubstrat aus mehreren Platinenschichten aufgebaut wird. Der schichtweise Aufbau ermöglicht, Leiterplatinen variabler Stärke und damit variabler Flexibilität herzustellen. Ferner besteht die Möglichkeit jede Platinenschicht individuell bearbeiten zu können.

Nach einer Weiterbildung des erfindungsgemäßen Verfahrens ist vorgesehen, dass das Bauelement in die Platinenschicht eingepresst wird. So kann zunächst die Platinenschicht hergestellt werden in der dann das Bauelement eingepresst ist. Es ist alternativ denkbar, das Bauelement nur bereichsweise innerhalb einer der Platinenschichten einzupressen. Der nicht eingepresste Teil kann anschließend in eine zweite zusätzliche Platinenschicht eingepresst werden, sodass sich das Bauelement innerhalb von zwei Platinenschichten befindet. Es ist von Vorteil, das eingepresste Bauelement dadurch zu isolieren, dass die Platinenschicht oder die Platinenschichten mittels weiterer Platinenschichten abgedeckt - laminiert - werden.

Nach einer Weiterbildung des erfindungsgemäßen Verfahrens ist vorgesehen, dass die Platinenschicht für das Einpressen des Bauelements erwärmt wird. Dies ist insbesondere dann vorteilhaft, wenn es sich bei dem verwendeten Material der Platinenschicht um ein thermoplastisches Material handelt, welches sich nach Beaufschlagung mit Wärme gut verformen lässt. Auf diese Weise erhält das Bauelement gleichzeitig eine optimale Passform innerhalb der Platinenschicht.

Das erfindungsgemäßen Verfahren sieht vor, dass die Platinenschicht mindestes bereichsweise mit mindestens einer elektrisch leitenden und/oder wärmeleitenden Leiterschicht beschichtet wird. Dabei ist vorgesehen, dass die Leiterschicht entweder bereichsweise angeordnet wird oder dass die Platinenschicht vollständig beschichtet wird, wobei anschließend Bereiche der Leiterschicht abgetragen werden.

Bei dem erfindungsgemäßen Verfahren ist vorgesehen, dass in der Leiterschicht mindestens eine randoffene Nut eingebracht wird. Jede randoffene Nut kann dabei insbesondere in ihrer Tiefe bezüglich der Leiterschicht unterschiedlich ausgeführt sein. So ist es denkbar, dass die randoffene Nut bereichsweise in die Leiterschicht eindringt oder die Leiterschicht vollständig bis zur Platinenschicht durchbricht. Die randoffene Nut kann dabei insbesondere durch ein strukturiertes Abtragen der Leiterschicht in Form eines Ätzens hergestellt werden.

Gemäß einer alternativen Ausführungsform des Verfahrens ist vorgesehen, dass die Platinenschicht und/oder die Leiterschicht von einer weiteren Platinenschicht und/oder einer weiteren Leiterschicht abgedeckt wird.

Bei dem erfindungsgemäßen Verfahren ist vorgesehen, dass ein Kühlmittelkanal aus der randoffenen Nut erzeugt wird, indem die randoffene Nut mit einer weiteren Platinenschicht und/oder mit einer weiteren Leiterschicht und/oder einer weiteren randoffenen Nut abgedeckt wird.

Bei dem erfindungsgemäßen Verfahren ist vorgesehen, dass mindestens ein Wärmeleitrohr ausgebildet wird, indem der Kühlmittelkanal mit einem Platinenschichtendurchbruch verbunden und von außen mit einem Kühlmittel befüllt wird, anschließend durch teilweises Absaugen des Kühlmittels ein Unterdruck erzeugt wird und abschließend der Platinenschichtendurchbruch mit einem wärmeleitenden Verschlusselement gasdicht verschlossen wird. Als Kühlmittel wird insbesondere eine Kühlflüssigkeit verwendet, die zur Kühlung in einen gasförmigen Zustand übergeht. Ein Verschließen des Platinenschichtendurchbruchs kann dabei beispielsweise durch Laserschweißen, Pfropfen und/oder Kleben erfolgen.

### Kurze Beschreibung der Zeichnungen

Die Zeichnungen veranschaulichen die Erfindung anhand von Ausführungsbeispielen, und zwar zeigt:
- Figur 1: einen Querschnitt durch eine Ausführung einer Leiterplatine,
- Figur 2: den Querschnitt der Leiterplatine aus Figur 1 mit Durchkontaktierungen und
- Figur 3: den Querschnitt der Leiterplatine aus Figur 2 mit Außenleiterschichten,
- Figur 4: eine weitere Ausführung der Leiterplatine im Querschnitt mit einer Platinenschicht als Halbbrücke,
- Figur 5: eine weitere Ausführung der Leiterplatine im Querschnitt mit drei Platinenschichten als Halbbrücke,
- Figur 6: eine weitere Ausführung der Leiterplatine im Querschnitt mit vier Platinenschichten als Halbbrücke,
- Figur 7: einen Schaltplan der Halbbrücke,
- Figur 8: eine weitere Ausführung der Leiterplatine im Querschnitt mit einer Platinenschicht als H-Brücke,
- Figur 9: eine weitere Ausführung der Leiterplatine im Querschnitt mit drei Platinenschichten als H-Brücke,
- Figur 10: eine weitere Ausführung der Leiterplatine im Querschnitt mit vier Platinenschichten als H-Brücke,
- Figur 11: einen Schaltplan der H-Brücke,
- Figur 12: eine weitere Ausführung der Leiterplatine im Querschnitt mit einer Platinenschicht als B6-Brücke,
- Figur 13: eine weitere Ausführung der Leiterplatine im Querschnitt mit drei Platinenschichten als B6-Brücke,
- Figur 14: eine weitere Ausführung der Leiterplatine im Querschnitt mit vier Platinenschichten als B6-Brücke,
- Figur 15: einen Schaltplan der B6-Brücke,
- Figur 16: eine weitere Ausführung der Leiterplatine im Querschnitt mit Wärmeleitrohr,
- Figur 17: ein alternatives Verschlusselement für das Wärmeleitrohr,
- Figur 18: eine weitere Ausführung der Leiterplatine im Querschnitt mit zwei Kühlrippenanordnungen,
- Figur 19: die Leiterplatine aus Figur 6 mit einem zusätzlichen Bauelement, das innerhalb des Platinensubstrats angeordnet ist und
- Figur 20: eine rotationssymmetrische Anordnung von drei Halbbrücken zur Montage auf einem Drehstrommotor.

### Ausführungsform(en) der Erfindung

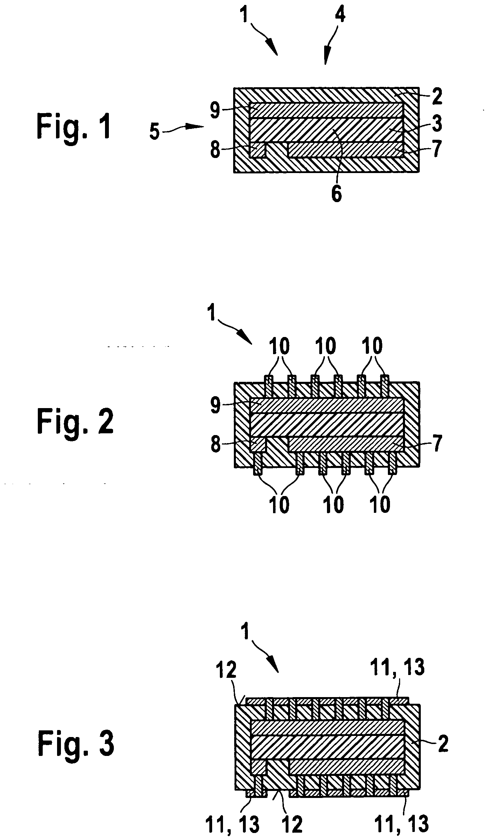

Die Figur 1 zeigt eine Ausführungsform einer Leiterplatine 1 im Querschnitt, bestehend aus einem flächigen, flexiblen Platinensubstrat 2 und einem darin angeordneten Bauelement 3. Die Leiterplatine 1 ist als Leiterplatte 4 ausgebildet, welche aus einer einzelnen Platinenschicht 5 besteht. Das Platinensubstrat 2 kann als Dielektrikum ausgeführt sein. Das Bauelement 3 ist als Transistor 6 ausgeführt, welcher einen Emitter 7, eine Basis 8 und einen Kollektor 9 aufweist. Die Figur 2 zeigt die Leiterplatine 1 aus Figur 1 mit all seinen Merkmalen, wobei die Leiterplatine 1 zusätzlich Durchkontaktierungen 10 aufweist. Dabei ist eine der Durchkontaktierungen 10 mit der Basis 8, fünf der Durchkontaktierungen 10 mit dem Emitter 7 und sechs der Durchkontaktierungen 10 mit der Basis 9 verbunden. Die Durchkontaktierung ragen aus dem Platinensubstrat 2 heraus.

Die Figur 3 zeigt die Leiterplatine 1 der Figur 2 mit all seinen in Figur 2 dargestellten Merkmalen. Zusätzlich ist die Leiterplatine 1 mit zwei Leiterschichten 11 versehen. Die Leiterschichten 11 befinden sich auf Oberflächen 12 des Platinensubstrats 2. Somit sind die Leiterschichten 11 als Außenleiterschichten 13 ausgebildet.

Die Figuren 1, 2 und 3 zeigen die Reihenfolge, in der die Leiterplatine 1 mit Durchkontaktierungen 10 versehen und anschließend mit Leiterschichten 11 beschichtet wird. Um die Durchkontaktierungen 10 herzustellen, wird in das Platinensubstrat 2 bis zum Bauelement 3 gebohrt. Eine auf diese Weise entstandene Bohrungsöffnung wird metallisiert. Soll die Durchkontaktierung 10 nur zur elektrischen Leitung dienen, wird typischerweise eine Beschichtung der Bohrungsöffnung vorgenommen. Dient die Durchkontaktierung 10 einer Wärmeleitung, wird die Bohrungsöffnung mit Metall ausgefüllt. Metalle für diesen Zweck können beispielsweise Kupfer, Silber, Gold und/oder Aluminium sein. Die gesamte Anordnung ist flexibel ausgeführt.

Anschließend wird das Platinensubstrat 2 auf seiner Oberfläche 12 mit der Leiterschicht 11 beschichtet. Die Leiterschicht 11 dient sowohl der elektrischen Leitung als auch der Wärmeableitung. Die Leiterschichten sind nur bereichsweise ausgeführt, um Emitter 7 und Basis 8 über die Durchkontaktierungen und die Leiterschicht 11 nicht elektrisch miteinander zu verbinden.

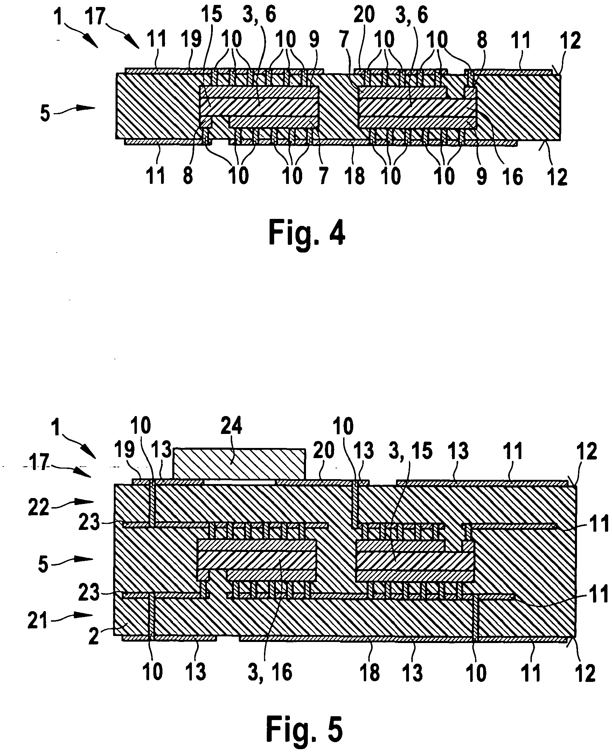

Die Figur 4 zeigt eine weitere Ausführung der Leiterplatine 1 im Querschnitt. Die Leiterplatine 1 besteht aus der Platinenschicht 5, in der zwei Bauelemente 3 angeordnet sind. Die Bauelemente 3 sind als Transistoren 6 ausgeführt, die jeweils den Emitter 7, die Basis 8 und den Kollektor 9 aufweisen. Ferner ist ein Bauelement 3 als High-Side-Transistor 15 und das andere Bauelement 3 als Low-Side-Transistor 16 ausgebildet. Die Bauelemente 3 sind über Durchkontaktierungen 10 mit den Leiterschichten 11 verbunden. Die Leiterschichten 11 befinden sich auf beiden Oberflächen 12 des Platinensubstrats 2 und sind derart angeordnet, dass der Kollektor 9 des High-Side-Transistors 15 mit dem Emitter 7 des Low-Side-Transistors 16 verbunden ist. Weitere elektrische Wirkverbindungen zwischen den Bauelementen 3 sind nicht gegeben. Aufgrund der elektrischen Wirkverbindung zwischen dem High-Side-Transistor 15 und dem Low-Side-Transistor 16 ergibt sich, dass die Leiterplatine 11 eine Halbbrücke 17 bildet. Die Halbbrücke 17 weist einen Verbraucheranschluss 18 auf, sowie einen Versorgungsanschluss 19 für eine positive Versorgungsspannung, und einen Versorgungsanschluss 20 für eine negative Versorgungsspannung. Die Versorgungsanschlüsse 19 und 20 sowie der Verbraucheranschluss 18 werden dabei durch die Leiterschichten 11 ausgebildet.

Die Figur 5 zeigt eine weitere Ausführungsform der Leiterplatine 1 im Querschnitt als Halbbrücke 17. Dabei weist die Leiterplatine 1 die gleichen Merkmale wie die Leiterplatine 1 der Figur 4 auf. Unterschiede sind dadurch gegeben, dass die Platinenschicht 5 auf einer Seite von einer weiteren Platinenschicht 21 und auf einer anderen Seite von einer weiteren Platinenschicht 22 abgedeckt ist. Daraus ergibt sich, dass die Leiterschichten 11, welche an die Platinenschicht 5 angrenzen, als Innenleiterschichten 23 ausgebildet sind. Ferner wurden der Verbraucheranschluss 18 und die Versorgungsanschlüsse 19 und 20 mittels Durchkontaktierungen 10, welche sich durch die Platinenschichten 21 und 22 hindurch erstrecken, auf Leiterschichten 11 verlegt, welche auf der Oberfläche 12 des Platinensubstrats 2 aufgebracht sind und somit als Außenleiterschichten 13 ausgebildet sind. Zusätzlich verbindet ein externes Bauelement 24 den Versorgungsanschluss 19 mit dem Versorgungsanschluss 20.

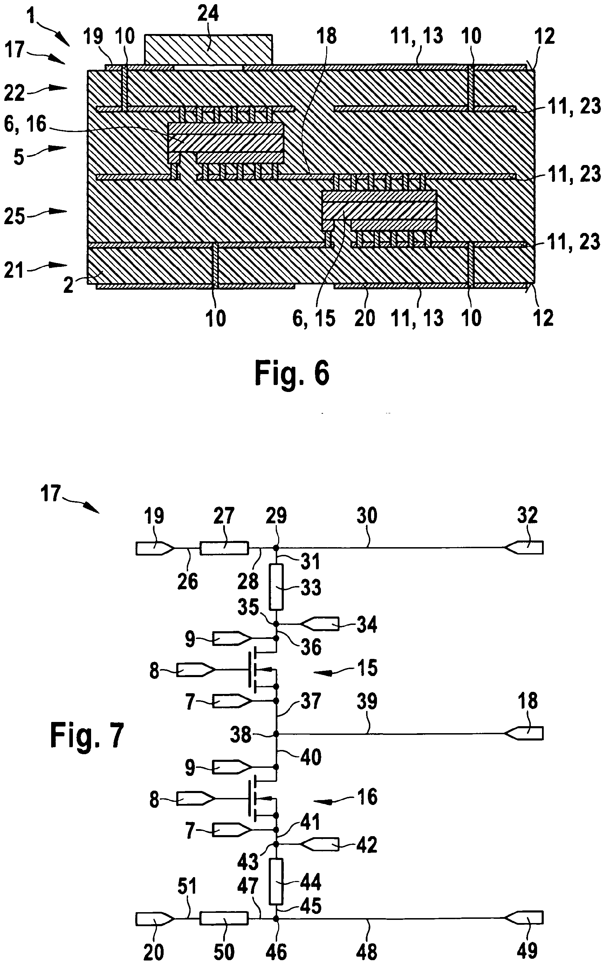

Die Figur 6 zeigt eine weitere Ausführung der Leiterplatine 1 im Querschnitt als Halbbrücke 17. Die Leiterplatine 1 weist die oberste Platinenschicht 22 auf, welcher die Platinenschicht 5 folgt, die von einer weiteren Platinenschicht 25 abgedeckt und abschließend von der untersten Platinenschicht 21 abgedeckt ist. Das Platinensubstrat 2 weist an seinen Oberflächen 12 sowie zwischen den Leiterschichten 22, 5, 25 und 21 jeweils die Leiterschicht 11 auf. Diese sind je nach Anordnung als Außenleiterschicht 13 oder als Innenleiterschicht 23 ausgebildet. Innerhalb der Platinenschicht 5 ist der Low-Side-Transistor 16 eingebracht und in der Leiterschicht 25 ist der High-Side-Transistor 15 eingebracht. Die Orientierung des High-Side-Transistors 15 sowie des Low-Side-Transistors 16 innerhalb der Leiterplatine 1 ist derart gewählt, dass die beiden Transistoren 6 elektrisch wie in den Figuren 4 und 5 miteinander verbunden werden können. Der Versorgungsanschluss 19 liegt dadurch auf einer der Oberflächen 12 wohingegen der Versorgungsanschluss 20 auf der anderen Oberfläche 12 des Platinensubstrats 2 angeordnet ist. Der Verbraucheranschluss 18 befindet sich mittig innerhalb des Platinensubstrats 2. Verbindungen zwischen den Bauelementen 3 und den Innenleiterschichten 23 sowie zwischen den Innenleiterschichten 23 und den Außenleiterschichten 13 werden mittels den Durchkontaktierungen 10 herbeigeführt. Ferner ist mit dem Versorgungsanschluss 19 ein externes Bauelement 24 verbunden.

Die Figur 7 zeigt einen Schaltplan, der die Schaltung der Halbbrücke 17 in den Figuren 4, 5 und 6 schematisch darstellt. Der Versorgungsanschluss 19 ist über eine Verbindung 26 mit einem Widerstand 27 elektrisch wirkverbunden. Der Widerstand 27 ist seinerseits über eine Verbindung 28 mit einem Knotenpunkt 29 verbunden. Vom Knotenpunkt 29 gehen zwei Verbindungen 30 und 31 aus, wobei die Verbindung 30 mit einem Shuntanschluss 32 einer nicht dargestellten Spannungsversorgung verbunden ist. Die Verbindung 31 verläuft zu einem Widerstand 33, welcher mit einem weiteren Shuntanschluss 34 über einen Knotenpunkt 35 elektrisch verbunden ist. Ausgehend vom Knotenpunkt 35 verläuft eine Verbindung 36 zum Kollektor 9 des High-Side-Transistors 15. Der High-Side-Transistor weist ferner die Basis 8 und den Emitter 7 auf. Der Emitter 7 ist über eine Verbindung 37 mit einem Knotenpunkt 38 verbunden. Ausgehend vom Knotenpunkt 38 verläuft eine weitere Verbindung 39 zu dem Verbraucheranschluss 18. Der Knotenpunkt 38 ist über eine weitere Verbindung 40 mit dem Kollektor 9 des Low-Side-Transistors 16 verbunden. Der Low-Side-Transistor 16 weist ebenfalls die Basis 8 und den Emitter 7 auf. Der Emitter 7 ist über eine Verbindung 41 mit einem Knotenpunkt 43 an einem Shuntanschluss 42 angeschlossen. Der Knotenpunkt 43 führt ferner zu einem Widerstand 44 und vom Widerstand 44 über eine Verbindung 45 zu einem weiteren Knotenpunkt 46.

Der Knotenpunkt 46 ist mit zwei weiteren Verbindungen 47 und 48 verbunden, wobei die Verbindung 48 zu einem weiteren Shuntanschluss 49 führt. Die Verbindung 47 führt zu einem Widerstand 50. Dieser ist abschließend über eine Verbindung 51 mit dem Versorgungsanschluss 20 verbunden. Die Widerstände 27, 33, 44 und 50 stellen Leitungswiderstände sowie Widerstände innerhalb der Stromversorgung dar.

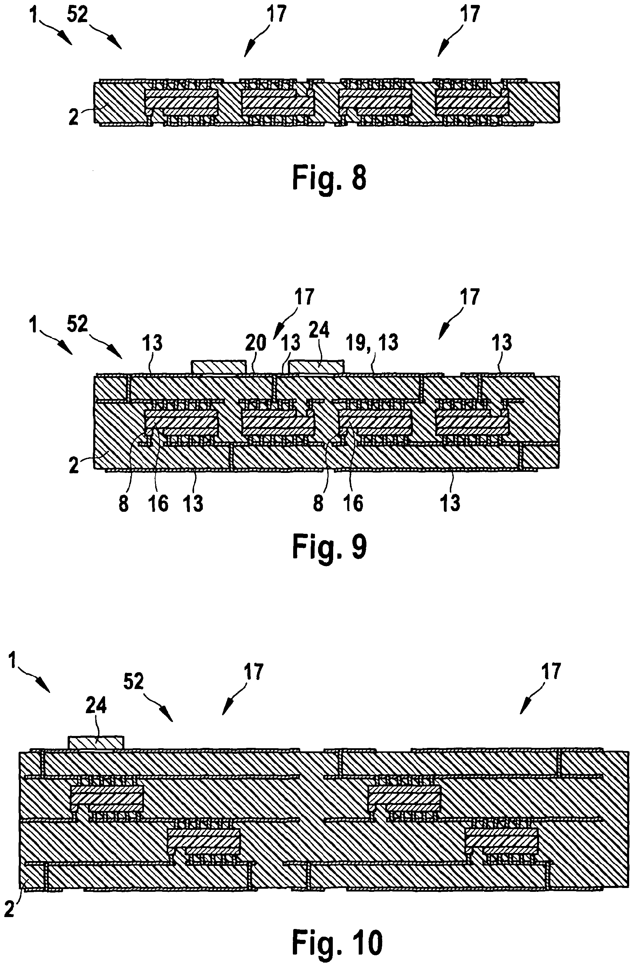

Die Figur 8 zeigt eine weitere Ausführung der Leiterplatine 1 im Querschnitt, die als eine H-Brücke 52 ausgeführt ist. Dabei weist die H-Brücke 52 zwei nebeneinander angeordnete Halbbrücken 17 der Figur 4 auf, mit all ihren Merkmalen. Die beiden Halbbrücken 17 sind über das Platinensubstrat 2 miteinander verbunden. Eine elektrische Verbindung zwischen den zwei Halbbrücken 17 ist in Figur 8 nicht dargestellt.

Die Figur 9 zeigt eine weitere Ausführungsform der Leiterplatine 1 im Querschnitt als H-Brücke 52. Die H-Brücke 52 besteht aus zwei Halbbrücken 17, welche nebeneinander angeordnet sind. Die Halbbrücken 17 sind dabei über das Platinensubstrat 2 miteinander verbunden. Die Halbbrücken 17 gleichen der Halbbrücke 17 aus Figur 5, mit dem Unterschied, dass die Außenleiterschichten 13 in Figur 9 andere Erstreckungen aufweisen, als die Außenleiterschichten 13 in Figur 5, dem Unterschied, dass die Basen 8 der Low-Side-Transistoren 16 nicht über Durchkontaktierungen 10 mit Außenleiterschichten 13 verbunden sind und dem Unterschied, dass der Versorgungsanschluss 20 einer der Halbbrücken 17 mit dem Versorgungsanschluss 19 der anderen Halbbrücke 17 über das externe Bauelement 24 verbunden ist.

Die Figur 10 zeigt eine weitere Ausführung der Leiterplatine 1 im Querschnitt als H-Brücke 52, welche aus zwei Halbbrücken 17 der Figur 6 besteht, die nebeneinander angeordnet sind. Die beiden Halbbrücken 17 sind über das Platinensubstrat 2 miteinander verbunden. Im Unterschied zu Figur 6 ist bei einer der Halbbrücken 17 das externe Bauelement 24 nicht vorhanden.

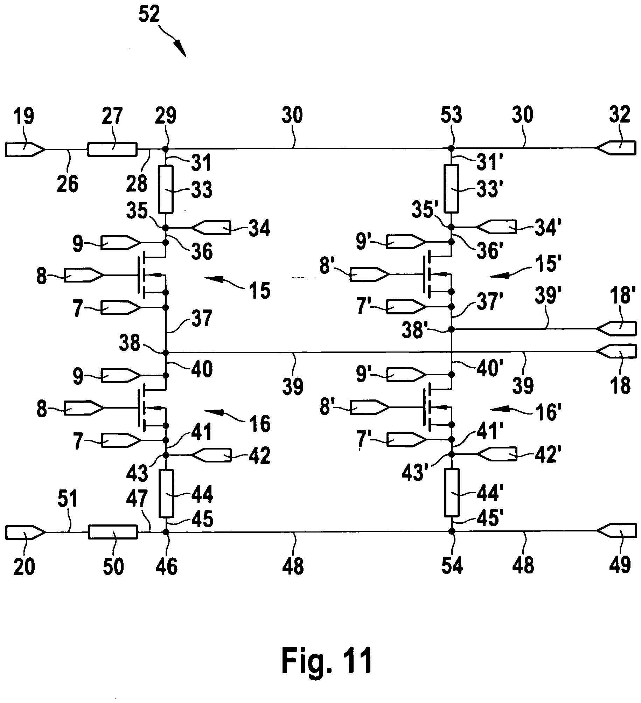

Die Figur 11 zeigt einen Schaltplan der H-Brücke 52. Der Schaltplan der Halbbrücke 52 gleicht dem Schaltplan der Haltebrücke 17 aus Figur 7 mit allen seinen Merkmalen, wobei in den Verbindungen 30 und 48 zusätzliche Knotenpunkte 53 und 54 eingebracht sind. Zwischen den Knotenpunkten 53 und 54 ist der Bereich des Schaltplans der Halbbrücke 17 dupliziert, der sich in Figur 7 zwischen den Knotenpunkten 29 und 46 befindet. Somit ergeben sich bei der H-Brücke 52 zwei Verbraucheranschlüsse 18 und 18', wohingegen weiterhin nur ein Versorgungsanschluss 19 und ein Versorgungsanschluss 20 verwendet wird. Aus Gründen der Unterscheidbarkeit sind die Bezugszeichen der Elemente, welche zwischen den Knotenpunkten 53 und 54 liegen, zusätzlich mit einem Hochkomma gekennzeichnet.

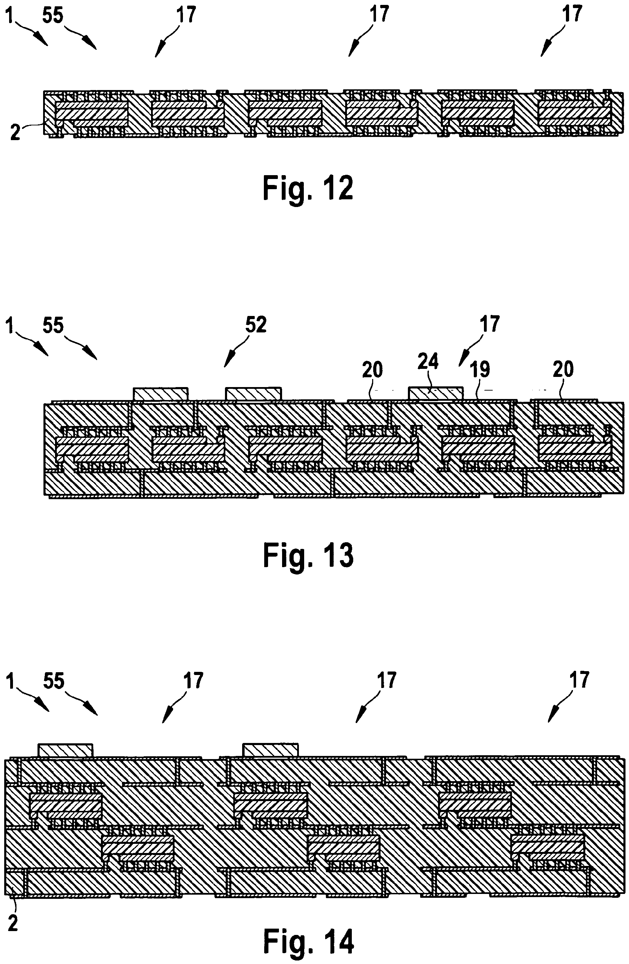

Die Figur 12 zeigt eine weitere Ausführung der Leiterplatine 1 im Querschnitt als B6-Brücke 55 ausgeführt ist. Diese besteht aus drei nebeneinander angeordneten Halbbrücken 17 der Figur 4. Die drei Halbbrücken 17 sind miteinander über das Platinensubstrat 2 verbunden. Eine elektrische Wirkverbindung ist in Figur 12 nicht dargestellt.

Die Figur 13 zeigt eine weitere Ausführung der Leiterplatine 1 im Querschnitt als B6-Brücke 55. Diese besteht aus der H-Brücke 52 der Figur 9, neben der eine Halbbrücke 17 der Figur 5 angeordnet ist. Die H-Brücke 52 ist mit der Halbbrücke 17 über das Bauelement 24 elektrisch wirkverbunden. Im Gegensatz zu Figur 5 weist die Halbbrücke 17 kein Bauelement 24 zwischen ihrem Versorgungsanschluss 19 und ihrem Versorgungsanschluss 20 auf. Das dargestellte, verbindende Bauelement 24 verbindet den Versorgungsanschluss 19 der Halbbrücke 17 mit dem Versorgungsanschluss 20 der H-Brücke 52.

Die Figur 14 zeigt eine weitere Ausführung der Leiterplatine 1 im Querschnitt als B6-Brücke 55. Die B6-Brücke 55 besteht aus drei Halbbrücken 17 der Figur 4 mit all ihren Merkmalen. Dabei sind die Halbbrücken 17 nebeneinander angeordnet und über das Platinensubstrat 2 miteinander verbunden. Eine elektrische Wirkverbindung zwischen den einzelnen Halbbrücken ist in Figur 14 nicht dargestellt.

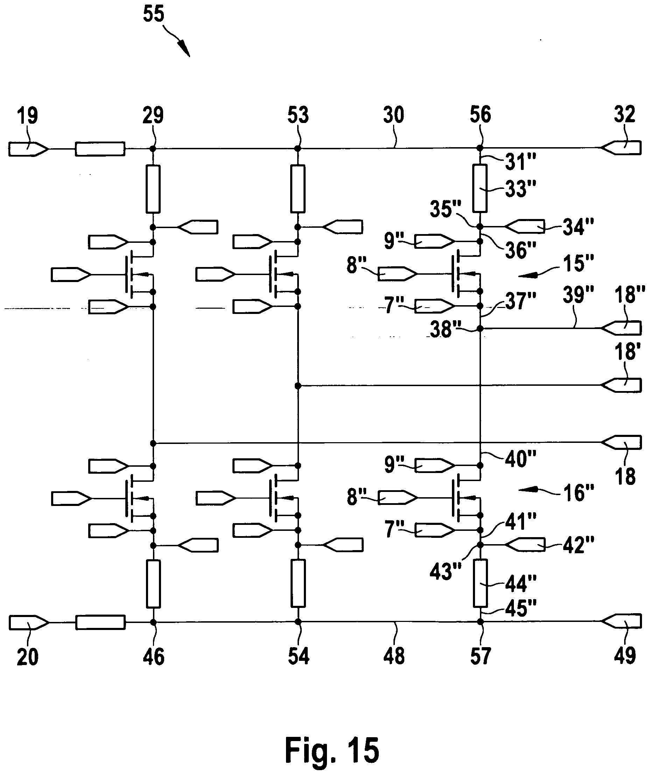

Die Figur 15 zeigt einen Schaltplan der B6-Brücke 55. Der Schaltplan der B6-Brücke 55 gleicht dem Schaltplan aus Figur 11 mit all seinen Merkmalen, wobei in Verbindung 30 und in Verbindung 48 jeweils ein zusätzlicher Knotenpunkt 56 und 57 angeordnet sind. Zwischen dem Knotenpunkt 56 und 57 ist der Bereich dupliziert, welcher sowohl in Figur 11 zwischen den Knotenpunkten 29 und 46 als auch zwischen den Knotenpunkten 53 und 54 vorliegt. Damit ergeben sich für die B6-Brücke 55 drei Verbraucheranschlüsse 18, 18' und 18". Aus Gründen der Unterscheidbarkeit sind die Bezugszeichen der Komponenten des Bereichs des Schaltplans zwischen dem Knotenpunkt 56 und dem Knotenpunkt 57 mit zwei Hochkommata gekennzeichnet.

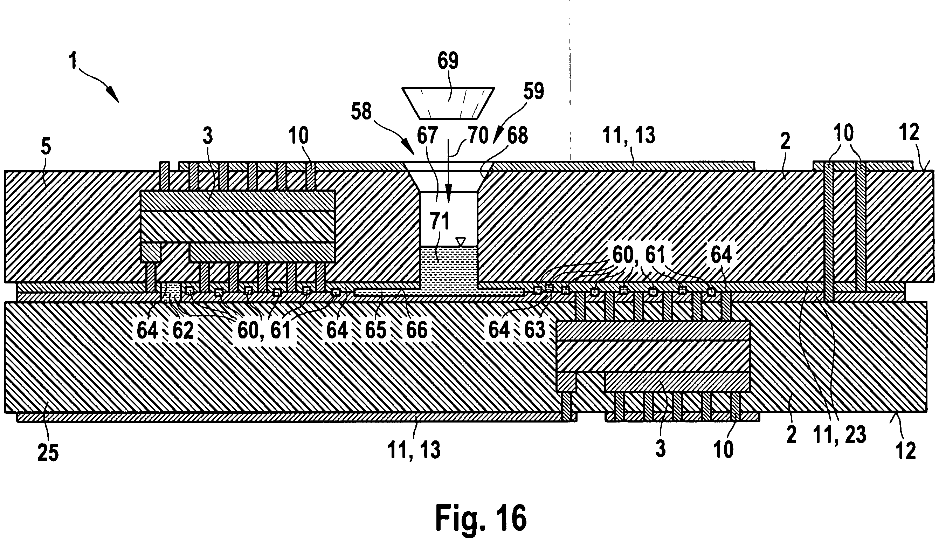

Die Figur 16 zeigt eine weitere Ausführung der Leiterplatine 1 im Querschnitt. Die Leiterplatine 1 weist die Platinenschicht 5 sowie die Platinenschicht 25 auf, in welcher jeweils ein Bauelement 3 eingebracht ist. Die Oberflächen 12 des Leitersubstrats 2 sind mit jeweils einer Leiterschicht 11 als Außenleiterschicht 13 versehen. Zwischen der Leiterschicht 5 und der Leiterschicht 25 sind zwei Leiterschichten 11 als Innenleiterschichten 23 angeordnet. Die Innenleiterschichten 23 liegen dabei in Berührkontakt zueinander. Die Innenleiterschichten 23 sind jeweils über Durchkontaktierungen 10 mit der Außenleiterschicht 13 verbunden. Ferner sind die Bauelemente 3 über eine Mehrzahl von Durchkontaktierungen 10 sowohl mit den Innenleiterschichten 23 als auch mit den Außenleiterschichten 13 verbunden. Die dargestellte Leiterplatine 1 besitzt eine Kühlvorrichtung 58. Die Kühlvorrichtung 58 besteht sowohl aus einem Wärmeleitrohr 59 sowie aus einer Mehrzahl an Kühlmittelkanälen 60.

Die Kühlmittelkanäle 60 bestehen jeweils aus einer randoffenen Nut 61, die in eine oder in beide der Innenleiterschichten 23 eingebracht ist. Die randoffenen Nuten 61 werden von der jeweils anderen Innenleiterschicht 23 abgedeckt, wodurch sich die Kühlmittelkanäle 60 bilden. Ferner ist ein Kühlmittelkanal 62 dargestellt, welcher aus zwei sich gegenüberliegenden randoffenen Nuten 61 besteht, welche die Innenleiterschicht 23 vollständig durchbrechen. Daraus ergibt sich ein besonders tiefer Kühlmittelkanal 62. Weiter ist ein Kühlmittelkanal 63 dargestellt, welcher nur in einer der Innenleiterschichten 23 als randoffene Nut 61 vorliegt. Die andere Innenleiterschicht 23 deckt die randoffene Nut 61 ab, um den Kühlmittelkanal 63 zu bilden. Somit wirken entweder eine der Innenleiterschichten 23, eine der Platinenschichten 5 oder 25 oder eine der randoffenen Nuten 61 als eine Abdeckung 64 für eine der randoffenen Nuten 61. Das Wärmeleitrohr 59 besteht aus einem Kühlmittelkanal 65, welcher eine, gegenüber den anderen Kühlmittelkanälen 60, sehr große Innenoberfläche 66 aufweist. Der Kühlmittelkanal 65 ist mit einem Platinenschichtendurchbruch 67 verbunden, welcher sich zur Oberfläche 12 hin mit einem Kegelstumpfbereich 68 aufweitet. Der Kegelstumpfbereich 68 ist derart ausgeführt, dass er ein Verschlusselement 69 dichtend in Richtung eines Pfeils 70 aufnehmen kann. Das Wärmeelement 69 ist kegelstumpfförmig ausgeführt und besteht aus einem gut wärmeleitenden Material. Innerhalb des Platinendurchbruchs 67 und damit innerhalb des Kühlmittelkanals 65 ist ein Kühlmittel 71 eingebracht.

Zur Herstellung des Wärmeleitrohrs 59 wird zunächst das Kühlmittel 71 aus dem Platinendurchbruch 67 und somit aus dem Kühlmittelkanal 65 teilweise abgesaugt, wodurch in den genannten Bereichen ein Unterdruck entsteht. Das Verschlusselement 69 wird in dem Kegelstumpfbereich 68 eingebracht, wodurch das Wärmeleitrohr gasdicht verschlossen wird. Besonders vorteilhaft ist es, das Verschlusselement durch Kleben oder Schweißen mit dem Kegelstumpfbereich 68 gasdicht zu verbinden.

Das Wärmeleitrohr 59 ermöglicht es, Wärme aus der Leiterplatine 1 herauszuleiten, welche sich im Bereich der Innenleiterschichten 23 befindet. Dies geschieht, indem das noch teilweise vorhandene Kühlmittel 71 am Kühlmittelkanal 65 aufgrund der Wärme als Gas vorliegt und sich zum Verschlusselement 69 verlagert. Da das Verschlusselement 69 wärmeleitend ausgeführt ist, kann es die Wärme des gasförmigen Kühlmittels 71 aufnehmen und nach außen abstrahlen. Das Kühlmittel 71 kondensiert dadurch und läuft in flüssiger Form zurück in den Kühlmittelkanal 65.

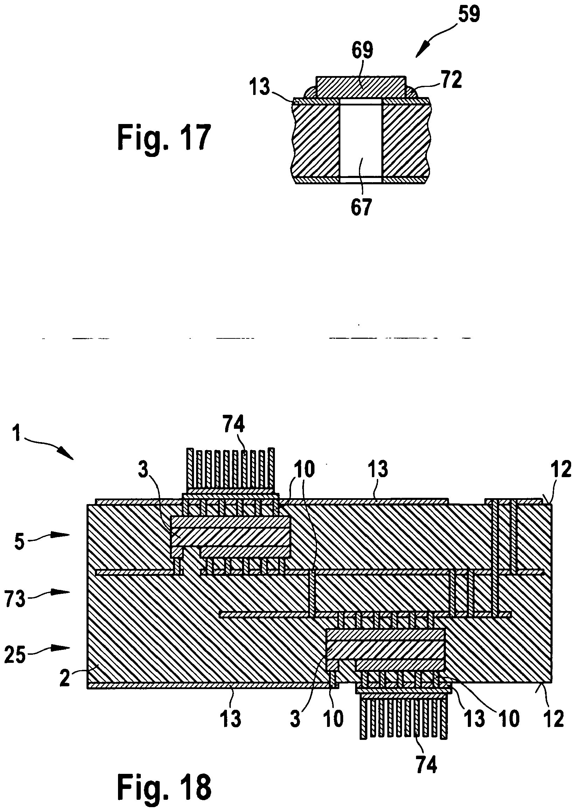

Die Figur 17 zeigt einen Ausschnitt der Figur 16 im Bereich des Wärmeleitrohrs 59. Der Platinendurchbruch 67 ist vollständig kreiszylinderförmig ausgeführt und weist keinen Kegelstumpfbereich 68 auf. Der Platinendurchbruch 67 ist mit einem alternativen Verschlusselement 69 verschlossen, welcher kreiszylinderartig ausgebildet ist und mittels eines Dichtmittels 72 mit der Außenleiterschicht 13 gasdicht verbunden ist.

Die Figur 18 zeigt eine weitere Ausführung der Leiterplatine 1 im Querschnitt mit der Platinenschicht 5, einer daran anliegenden Platinenschicht 73 und der Platinenschicht 25. Sowohl in der Platinenschicht 5 als auch in der Platinenschicht 25 ist jeweils ein Bauelement 3 angeordnet. Das Platinensubstrat 2 weist an seinen Oberflächen 12 jeweils bereichsweise die Außenleiterschicht 13 auf, welche über die Durchkontaktierungen 10 mit Bauelementen 3 verbunden sind. In den Bereichen der Außenleiterschichten 13, in denen die Bauelemente 3 mehrfach über die Durchkontaktierung 10 mit jeweils der Außenleiterschichten 13 verbunden sind, sind jeweils eine Kühlrippenanordnung 74 auf die Außenleiterschicht 13 aufgebracht. Die Kühlrippenanordnung 74 leitet Wärme von der Außenleiterschicht 13 an die Umgebungsluft ab. Somit werden die Bauelemente 3 über die Durchkontaktierungen 10 und die Außenleiterschicht 13 mittels der Kühlrippenanordnungen 74 gekühlt.

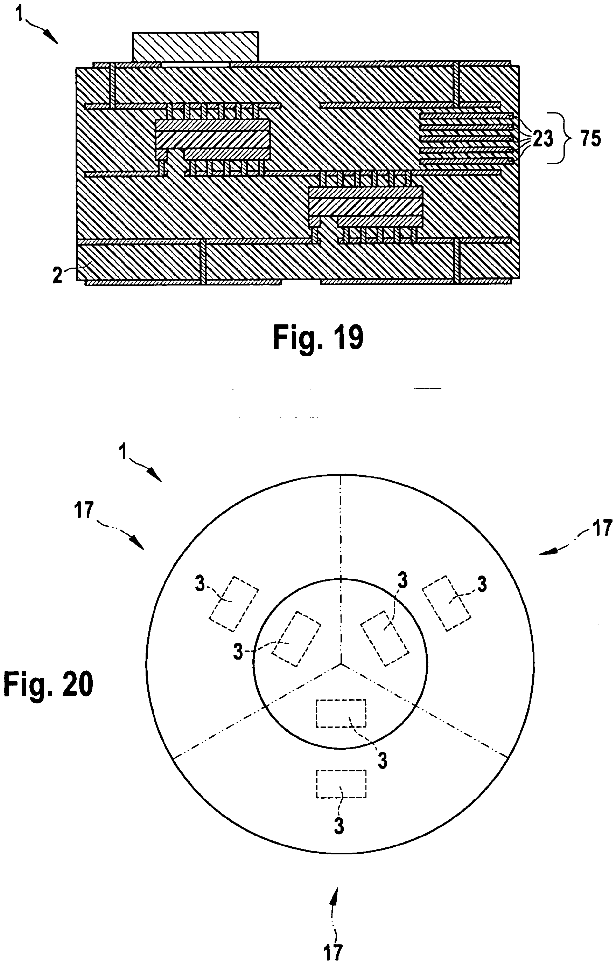

Die Figur 19 zeigt die Leiterplatine 1 aus Figur 6 im Querschnitt mit all seinen Merkmalen. Zusätzlich sind Innenleiterschichten 23 innerhalb des Platinensubstrats 2 angeordnet. Die Innenleiterschichten 23 sind plattenartig ausgeführt und bilden einen Plattenkondensator 75.

Die Figur 20 zeigt eine Draufsicht der Leiterplatine 1. Die Leiterplatine 1 ist kreisförmig und weist drei Halbbrücken 17 auf, welche rotationssymmetrisch zum Mittelpunkt der Leiterplatte 1 angeordnet sind. Jede der Halbbrücken 17 weist zwei Bauelemente 3 auf, welche radial zum Mittelpunkt hintereinander angeordnet sind. Es ist denkbar, derartige Anordnungen auch mit mehr als drei Halbbrücken 17 auszuführen.

## Patentansprüche

1. Leiterplatine (1) mit einem flächigen Platinensubstrat (2) und mit mindestens einem elektronischen Bauelement (3), das innerhalb des Platinensubstrats (2) angeordnet ist, wobei das Platinensubstrat (2) mehrere, übereinander liegende, elektrisch isolierende Platinenschichten (5,21,22,25,73) aufweist und wobei das Bauelement (3) innerhalb einer der Platinenschichten (5,21,22,25,73) angeordnet ist, wobei die Leiterplatine (1) mindestens bereichsweise mindestens eine elektrisch leitende und/oder wärmeleitende Leiterschicht (11) als Innenleiterschicht (23) zwischen zwei benachbarten Platinenschichten (5,21,22,25,73) sowie eine Kühlvorrichtung (58) zur Kühlung von mindestens einer der Platinenschichten (5,21,22,25,73) und/oder der Leiterschicht (11) aufweist, wobei die Kühlvorrichtung (58) zwischen zwei Platinenschichten (5,21,22,25,73) mindestens einen Kühlmittelkanal (60,62,63,65) aufweist, der als randoffene Nut (61) in der Leiterschicht (11) ausgebildet ist, wobei die randoffene Nut (61) von einer Abdeckung (64) abgedeckt ist, die eine weitere Innenleiterschicht (66) und/oder eine Platinenschicht (5,21,22,25,73) und/oder eine weitere randoffene Nut (61) eines weiteren Kühlmittelkanals ist, und wobei der Kühlmittelkanal (60,62,63,65) als Wärmeleitrohr (59) ausgebildet ist, indem er mit einem Platinenschichtendurchbruch (67) verbunden und von außen mit einem Kühlmittel (71) befüllt ist, wobei durch teilweises Absaugen des Kühlmittels ein Unterdruck in dem Kühlmittelkanal (60,62,63,65) erzeugt ist und der Platinenschichtendurchbruch mit einem wärmeleitenden Verschlusselement (69) gasdicht verschlossen ist.

2. Leiterplatine (1) nach Anspruch 1, **dadurch gekennzeichnet, dass** sie als Leiterplatte (4) ausgebildet ist.

3. Leiterplatine (1) nach einem oder mehreren der vorhergehenden Ansprüche, **gekennzeichnet durch** mindestens eine Durchkontaktierung (10), die die Leiterschicht (11) und/oder das Bauelement (3) mit mindestens einer weiteren Leiterschicht (11) und/oder mit mindestens einem weiteren Bauelement (3) elektrisch und/oder wärmeleittechnisch miteinander verbindet.

4. Leiterplatine (1) nach einem oder mehreren der vorhergehenden Ansprüche, **dadurch gekennzeichnet, dass** sie als flexible Leiterplatine (1) ausgebildet ist.

5. Verfahren zur Herstellung einer Leiterplatine (1), insbesondere nach einem oder mehreren der vorhergehenden Ansprüche, mit einem flächigen Platinensubstrat (2), dem mindestens ein elektronisches Bauelement (3) zugeordnet wird, wobei das Bauelement (3) innerhalb des aus mehreren Platinenschichten (5,21,22,25,73) aufgebauten Platinensubstrats (2) angeordnet wird, wobei das Bauelement (3) innerhalb einer der Platinenschichten (5,21,22,25,73) angeordnet und die Platinenschicht (5,21,22,25,73) mindestens bereichsweise mit mindestens einer elektrisch leitenden und/oder wärmeleitenden Leiterschicht (11) als Innenleiterschicht (23) zwischen zwei benachbarten Platinenschichten (5,21,22,25,73) beschichtet wird, wobei in die Leiterschicht (11) mindestens eine randoffene Nut (61) eingebracht und ein Kühlmittelkanal (60,62,63,65) aus der randoffenen Nut (61) erzeugt wird, indem die randoffene Nut (61) mit einer weiteren Platinenschicht (5,21,22,25,73) und/oder mit einer weiteren Leiterschicht (11) und/oder einer weiteren randoffenen Nut (61) abgedeckt wird, und wobei mindestens ein Wärmeleitrohr (59) ausgebildet wird, indem der Kühlmittelkanal (60,62,63,65) mit einem Platinenschichtendurchbruch (67) verbunden und von außen mit einem Kühlmittel (71) befüllt wird, anschließend durch teilweises Absaugen des Kühlmittels (71) ein Unterdruck erzeugt und abschließend der Platinenschichtendurchbruch (67) mit einem wärmeleitenden Verschlusselement (69) gasdicht verschlossen wird.

6. Verfahren nach Anspruch 5, **dadurch gekennzeichnet, dass** das Bauelement (3) in die Platinenschicht (5,21,22,25,73) eingepresst wird.

7. Verfahren nach einem oder mehreren der vorhergehenden Ansprüche, **dadurch gekennzeichnet, dass** die Platinenschicht (5,21,22,25,73) für das Einpressen des Bauelements (3) erwärmt wird.

## Claims

1. Circuit board (1) having a two-dimensional board substrate (2) and having at least one electronic component (3) which is arranged within the board substrate (2), wherein the board substrate (2) has a plurality of electrically insulating board layers (5, 21, 22, 25, 73) which are situated above one another and wherein the component (3) is arranged within one of the board layers (5, 21, 22, 25, 73), wherein the circuit board (1) has, at least in regions, at least one electrically conductive and/or thermally conductive conductor layer (11) as an internal conductor layer (23) between two adjacent board layers (5, 21, 22, 25, 73) and also a cooling apparatus (58) for cooling at least one of the board layers (5, 21, 22, 25, 73) and/or the conductor layer (11), wherein the cooling apparatus (58) has, between two board layers (5, 21, 22, 25, 73), at least one coolant channel (60, 62, 63, 65) which is in the form of a groove (61), which is open at the edge, in the conductor layer (11), wherein the edge-open groove (61) is covered by a cover (64) which is a further internal conductor layer (66) and/or a board layer (5, 21, 22, 25, 73) and/or a further edge-open groove (61) of a further coolant channel, and wherein the coolant channel (60, 62, 63, 65) is in the form of a thermally conductive tube (59) by virtue of it being connected to a board layer perforation (67) and being filled with a coolant (71) from the outside, wherein a negative pressure has been produced in the coolant channel (60, 62, 63, 65) by means of partial aspiration of the coolant, and the board layer perforation has been sealed in gas-tight fashion with a thermally conductive sealing element (69).

2. Circuit board (1) according to Claim 1, **characterized in that** it is in the form of a printed circuit board (4).

3. Circuit board (1) according to one or more of the preceding claims, **characterized by** at least one plated-through hole (10) which connects the conductor layer (11) and/or the component (3) to at least one further conductor layer (11) and/or to at least one further component (3) electrically and/or by means of a thermal conduction technique.

4. Circuit board (1) according to one or more of the preceding claims, **characterized in that** it is in the form of a flexible printed circuit board (1).

5. Method for producing a circuit board (1), particularly according to one or more of the preceding claims, having a two-dimensional board substrate (2) which is assigned at least one electronic component (3), wherein the component (3) is arranged within the board substrate (2), which is constructed from a plurality of board layers (5, 21, 22, 25, 73), wherein the component (3) is arranged within one of the board layers (5, 21, 22, 25, 73) and the board layer (5, 21, 22, 25, 73) is coated, at least in regions, with at least one electrically conductive and/or thermally conductive conductor layer (11) as an internal conductor layer (23) between two adjacent board layers (5, 21, 22, 25, 73), wherein the conductor layer (11) has at least one edge-open groove (61) made in it and a coolant channel (60, 62, 63, 65) is produced from the edge-open groove (61) by virtue of the edge-open groove (61) being covered with a further board layer (5, 21, 22, 25, 73) and/or with a further conductor layer (11) and/or a further edge-open groove (61), and wherein at least one thermally conductive tube (59) is produced by virtue of the coolant channel (60, 62, 63, 65) being connected to a board layer perforation (67) and being filled with a coolant (71) from the outside, then a negative pressure being produced by means of partial aspiration of the coolant (71), and finally the board layer perforation (67) being sealed in gas-tight fashion with a thermally conductive sealing element (69).

6. Method according to Claim 5, **characterized in that** the component (3) is pressed into the board layer (5, 21, 22, 25, 73).

7. Method according to one or more of the preceding claims, **characterized in that** the board layer (5, 21, 22, 25, 73) is heated for the purpose of pressing in the component (3).

## Revendications

1. Carte de circuit (1) qui présente un substrat plat (2) de carte et au moins un composant électronique (3) disposé à l'intérieur du substrat (2) de carte, le substrat (2) de carte présentant plusieurs couches électriquement isolantes (5, 21, 22, 25, 73) de carte disposées les unes au-dessus des autres, le composant (3) étant disposé à l'intérieur d'une des couches (5, 21, 22, 25, 73) de carte,
au moins certaines parties de la carte (1) de circuit présentant au moins une couche (11) électriquement et/ou thermiquement conductrice en tant que couche conductrice intérieure (23) entre deux couches voisines (5, 21, 22, 25, 73) de carte ainsi qu'un dispositif de refroidissement (58) qui refroidit au moins l'une des couches (5, 21, 22, 25, 73) de carte et/ou la couche conductrice (11),
le dispositif de refroidissement (58) présentant entre deux couches (5, 21, 22, 25, 73) de carte au moins un canal (60, 62, 63, 65) de fluide de refroidissement configuré comme rainure (61) à bords ouverts ménagée dans la couche conductrice (11), la rainure (61) à bords ouverts étant recouverte par un recouvrement (64) qui est une autre couche conductrice intérieure (66), une couche (5, 21, 22, 25, 73) de carte et/ou une autre rainure (61) à bords ouverts d'un autre canal de fluide de refroidissement,
le canal (60, 62, 63, 65) de fluide de refroidissement étant configuré comme tube caloporteur (59) relié à une perforation (67) traversant les couches de carte et rempli de l'extérieur d'un fluide de refroidissement (71), une aspiration d'une partie du fluide de refroidissement formant une dépression dans le canal (60, 62, 63, 65) de fluide de refroidissement et la perforation traversant les couches de la carte étant fermée de manière étanche au gaz par un élément thermiquement conducteur de fermeture (69).

2. Carte de circuit (1) selon la revendication 1, **caractérisée en ce qu'**elle est configurée comme carte de circuit (4).

3. Carte de circuit (1) selon l'une ou plusieurs des revendications précédentes, **caractérisée par** au moins une traversée de contact (10) qui relie de manière électriquement et/ou thermiquement conductrice la couche conductrice (11) et/ou le composant (3) à au moins une autre couche conductrice (11) et/ou à au moins un autre composant (3).

4. Carte de circuit (1) selon l'une ou plusieurs des revendications précédentes, **caractérisée en ce qu'**elle est configurée comme carte de circuit (1) flexible.

5. Procédé de fabrication d'une carte de circuit (1), en particulier selon l'une ou plusieurs des revendications précédentes et présentant au moins un substrat plat (2) de carte auquel au moins un composant électronique (3) est associé, le composant (3) étant disposé à l'intérieur du substrat (2) de carte constitué de plusieurs couches de carte (5, 21, 22, 25, 73), le composant (3) étant disposé à l'intérieur de l'une des couches (5, 21, 22, 25, 73) de carte et les couches (5, 21, 22, 25, 73) de carte étant revêtues au moins en partie par au moins une couche électriquement et/ou thermiquement conductrice (11) qui présente la forme d'une couche conductrice intérieure (23) située entre deux couches voisines (5, 21, 22, 25, 73) de carte, au moins une rainure (61) à bords ouverts étant ménagée dans la couche conductrice (11) et un canal (60, 62, 63, 65) de fluide de refroidissement étant formé de la rainure (61) à bords ouverts par le fait que la rainure (61) à bords ouverts est recouverte par autre couche (5, 21, 22, 25, 73) de la carte, par une autre couche conductrice (11) et/ou une autre rainure (61) à bords ouverts, au moins un tube caloporteur (59) étant formé par le fait que le canal (60, 62, 63, 65) de fluide de refroidissement est relié à une perforation (67) qui traverse les couches de la carte et est rempli de l'extérieur d'un fluide de refroidissement (71), une dépression étant ensuite formée en aspirant une partie du fluide de refroidissement (71) et la perforation (67) traversant les couches de carte étant ensuite fermée de manière étanche au gaz par un élément thermiquement conducteur de fermeture (69).

6. Procédé selon la revendication 5, **caractérisé en ce que** le composant (3) est enfoncé dans la couche (5, 21, 22, 25, 73) de carte.

7. Procédé selon l'une ou plusieurs des revendications précédentes, **caractérisé en ce que** la couche (5, 21, 22, 25, 73) de carte est chauffée pour permettre d'y enfoncer le composant (3).
